# EUROPEAN PATENT SPECIFICATION

(11) **EP 4 155 740 B1**
(45) Date of publication and mention of the grant of the patent: **20.08.2025**
(21) Application number: 21306315.9
(22) Date of filing: 23.09.2021
(51) Int. Cl.: G01R 31/12, G01R 31/59, G01R 31/14

(54) **PARTIAL DISCHARGE TEST OF FACTORY JOINTS**
TEILENTLADUNGSTEST VON FABRIKVERBINDUNGEN
TEST DE DÉCHARGE PARTIELLE DE JOINTS D'USINE

(43) Date of publication of application: 29.03.2023
(73) Proprietor: Nexans, 92400 Courbevoie (FR)
(72) Inventor: CLASEN, Geir, 1781 HALDEN (NO)
(74) Representative: Cabinet Boettcher

(56) References cited:
- CN-A- 108 802 582
- CN-U- 205 120 761
- DE-A1- 102017 011 671
- JP-A- 2012 220 215

## Description

### FIELD OF THE INVENTION

The present invention relates to a system for performing a partial discharge test of a factory joint joining a first high voltage cable section and a second high voltage cable section. The present invention also relates to a method for performing a test of a joined cable.

### BACKGROUND OF THE INVENTION

A partial discharge test is performed when testing the quality of the insulation of electric cables.

FR2389900 describes how the insulation of a high voltage cable is tested during manufacturing by a test in which short high voltage pulses are used to provoke partial discharges by ionisation. A cable from an extruder travels at high speed through processing areas which include cooling. An electrode conducts to ground. A group of electrodes form a test station where test pulses from a high voltage generator are applied for detection of faults. Detected signals are applied via differential input amplifier to coupling circuit which isolates high voltages from detected signal. The signal is amplified and applied to oscilloscope and recording instruments. Faults are indicated by marking on cable or by an audible warning indicator.

One weakness of the above method is that the sensitivity of the partial discharge test is low due to the moving cable. Therefore, a high sensitivity partial discharge test is typically performed by energizing the entire length of cable over a period of time.

In some applications, high voltage cables are manufactured in cable sections and each cable section is tested individually by a high sensitivity partial discharge test. Then, the cable sections are joined to form a desired length of cable. The cable sections may be joined by means of so-called factory joints, where the purpose of the factory joint is to maintain electrical and mechanical properties, while avoiding considerable increase in the outer diameter of the joint relative to the outer diameter of the cable sections. The reason for the use of the factory joint is to be able to spool the joined high voltage cable onto a larger turntable before transportation to the installation site.

Alternatively, the respective cable sections are transported to the installation site individually and then joined at the installation site, typically by using larger joints. However, this alternative is not a viable option for some applications, in particular for sea cables, where the operation of joining cables must be performed on a ship, which is costly, and which is vulnerable to abruptions caused by unfavourable weather conditions.

The insulation of a factory joint is typically tested together with the testing of the insulation of the cable sections, i.e. and entire length of joined cable (comprising cable sections and the factory joints) is tested in one operation. Today, it is considered possible to perform a partial discharge test of a 250 kV rated joined cable having a length up to 50 km. However, it is not considered possible to perform a partial discharge test of longer lengths of joined cables at this voltage level and/or to perform a partial discharge test at higher voltage levels at this length. One reason is that it is not possible to energize the entire length of joined high voltage cable.

Documents JP2012220215, CN108802582, CN205120761 and DE102017011671 are also directed to methods for testing a cable comprising a cable joint.

Hence, one object of the present invention is to provide a system and method for performing a partial discharge test on longer lengths of joined cables and/or for performing a partial discharge test on higher voltage levels.

### SUMMARY OF THE INVENTION

The present invention relates to a system for performing a partial discharge test of a factory joint joining a first high voltage cable section and a second high voltage cable section;
wherein the first cable section comprises a first conductor and a first semiconductive sheath;
wherein the second cable section comprises a second conductor and a second semiconductive sheath;
wherein the factory joint comprises a joint conductor joining the first conductor and the second conductor and a joint semiconductive sheath joining the first semiconductive sheath and the second semiconductive sheath;
wherein the system comprises:
   - a first insulation system for electrically insulating a joint side part of the first semiconductive sheath from a remaining part of the first semiconductive sheath;
   - a second insulation system for electrically insulating a joint side part of the second semiconductive sheath from a remaining part of the second semiconductive sheath;
   - a first earthing conductor for grounding the remaining part of the first semiconductive sheath;
   - a second earthing conductor for grounding the remaining part of the second semiconductive sheath;
   - a third earthing conductor for grounding the first conductor and/or the second conductor;
   - a high voltage transformer for supplying a test voltage to the semiconducting sheath of the factory joint during a test period;
   - a partial discharge sensing system for sensing partial discharges in the factory joint during the test period.

In one aspect, the first cable section comprises a proximal end proximal to the factory joint and a distal end and the second cable section comprises a proximal end proximal to the factory joint and a distal end.

The joint conductor is joining the proximal end of the first conductor and the proximal end of the second conductor. The joint semiconductive sheath is joining the proximal end of the first semiconductive sheath and the proximal end of the second semiconductive sheath.

In one aspect, the third earthing conductor is grounding the first conductor at its distal end and/or is grounding the second conductor at its distal end. By grounding either the first conductor at its distal end or grounding the second conductor at its distal end, the entire conductor, i.e. the first conductor, the joint conductor and the second conductor is considered to be grounded.

In one aspect, the joint side part of the first semiconductive sheath is provided at a distance from the remaining part of the first semiconductive sheath by removal of the first semiconductive sheath from a section of the first cable between the joint side part of the first semiconductive sheath and the remaining part of the first semiconductive sheath.

In one aspect, the section of the first cable from which the first semiconducting sheath has been removed is provided in the proximal end of the first cable section.

In one aspect, the first insulation system comprises:
- a non-metallic housing comprising a compartment in which the section of the first cable from which the first semiconducting sheath has been removed is provided;
- a fluid-circulating system for circulating de-ionized water through the compartment during the test.

In one aspect, the joint side part of the second semiconductive sheath is provided at a distance from the remaining part of the second semiconductive sheath by removal of the second semiconductive sheath from a section of the second cable between the joint side part of the second semiconductive sheath and the remaining part of the second semiconductive sheath.

In one aspect, the section of the second cable from which the second semiconducting sheath has been removed is provided in the proximal end of the second cable section.

In one aspect, the second insulation system comprises:
- a non-metallic housing comprising a compartment in which the section of the second cable from which the second semiconducting sheath has been removed is provided;
- a fluid-circulating system for circulating de-ionized water through the compartment during the test.

In one aspect, the third earthing conductor is grounding the first conductor at its distal end; and wherein the system comprises a fourth earthing conductor for grounding the second conductor at its distal end.

In one aspect, the partial discharge sensing system comprises a balanced partial discharge detector and an analysing system provided in communication with the balanced partial discharge detector by means of a fibre optic cable.

Alternatively, the cable sections, the high voltage transformer and the partial discharge sensing system may be located within a Faraday cage, and the partial discharge detector may be an unbalanced partial discharge detector.

In one aspect, the high voltage transformer comprises a 50/60 Hz transformer, a variable inductance series resonance high voltage generator or a variable frequency series resonance high voltage generator.

In one aspect, the first cable section is at least partially spooled onto a first drum and wherein the second cable section is at least partially spooled onto a second drum

The present invention also relates to a method for performing a test of a joined cable, wherein the method comprises:
- testing a first cable section;
- testing a second cable section;
- joining the first cable section and the second cable section by means of a factory joint to form the joined cable;
- performing a partial discharge test of the factory joint;
- electrically insulating a joint side part of the first semiconductive sheath from a remaining part of the first semiconductive sheath;
- electrically insulating a joint side part of the second semiconductive sheath from a remaining part of the second semiconductive sheath;
- grounding the remaining part of the first semiconductive sheath;
- grounding the remaining part of the second semiconductive sheath;
- grounding a first conductor of the first cable and/or a second conductor of the second cable;
- applying a test voltage to a semiconducting sheath of the factory joint during a test period;
- sensing partial discharges in the factory joint during the test period.

In one aspect, the step of testing the first cable section comprises:
- testing the first cable section by means of a high voltage withstand test or a partial discharge test.

In one aspect, the step of testing the second cable section comprises:
- testing the second cable section by means of a high voltage withstand test or a partial discharge test.

In one aspect, the method comprises:
- testing a third cable section;
- joining the third cable section to the previously joined cable by means of a further factory joint;
- performing a partial discharge test of the further factory joint.

In one aspect, as the high voltage transformer is supplying the test voltage to the semiconducting sheath of the factory joint, the test voltage will also be supplied to the joint side part of the first semiconductive sheath and to the joint side part of the second semiconductive sheath, due to the conducting properties of the semiconducting sheaths.

The joined cable is defined with a longitudinal direction. The term "joint side part" is here used to refer to a part which is relatively closer to the joint than other parts. The "joint side part" will be closer to the joint in the longitudinal direction of the cable than such other parts.

The term "factory joint" is here used to describe a joint used to join two cable sections, wherein the joined cable, i.e. the two cable sections together with the joint, has substantially the same mechanical/electrical properties as the respective cable sections. In particular, the outer diameter of the factory joint is equal to, or only slightly larger than, the outer diameter of the two cable sections. Consequently, the joined cable can be handled as a single cable without any consideration related to the location of the joint. According to the CIGRE publication "Recommendations for Testing of Long AC Submarine Cables with Extruded Insulation for System Voltage above 30 (36) to 500 (550) kV" TB 490 chapter 4.1, a factory joint is manufactured prior to the armouring operation, so that the section of cable containing the joint is continuously armoured without any discontinuity or appreciable distortion of the armour wires in the vicinity of the joint. One main feature of a factory joint is that it shall not impose any restrictions on further cable handling or installation operations, nor imply a variation in the cable mechanical and electrical performance. This generally implies that the factory joints are fully flexible, with same bending radius, pulling force limit and coiling performance with respect to the original cable.

Moreover, the above CIGRE publication states that "The defined length of a factory joint is the removed length of the metal sheath/outer semi-conducting screen plus 1 metre on each side of that length (...). For three-core cables, the length of the factory joint is defined from the beginning of first core joint to the end of the last core joint, plus 1 metre in each end of the core joints."

The opposite of a factory joint is typically referred to as an "on site joint", which is used to join two cable sections on the installation site. Such joints typically have a size considerably larger than the outer diameter of the cable sections, and the joined cable cannot be handled as one single cable.

The term "partial discharge test" is here used to describe a test used to test the properties, in particular the electrical insulation properties, of the insulation layer between the conductor and the semiconductive sheath.

The term "high voltage" is here used for nominal voltages above 36 kV. As an example, the term "high voltage" may be in the range 36 kV - 1000 kV, in the range 36 kV - 2000 kV or in the range 36 kV and up to even higher voltages.

In one aspect, the test voltage is a test voltage according to CIGRE TB 490 cl 6.4 and IEC 60840 & 62067 cl 9.2. Hence, one test criteria indicating a successful test is that measured partial discharges above a predetermined amount of picoColoumbs in the factory joint is less than a predetermined number during the test period.

According to the invention above, it is achieved a system and method where the factory joint can be tested with high sensitivity. The term "high sensitivity" here refers to being able to measure partial discharges of 5 - 10 picoColoumbs.

According to the above, by first testing each cable section individually, and then by testing each factory joint separately, the entire joined high voltage cable can be considered tested.

### DETAILED DESCRIPTION

Embodiments of the invention will now be described in detail with reference to the enclosed drawings, wherein:
Fig. 1a illustrates a cross section of a prior art high voltage cable schematically;
Fig. 1b illustrates a cross section of a prior art factory joint schematically;
Fig. 1c illustrates a cross sectional side view of a prior art factory joint schematically;
Fig. 2 illustrates a first cable section joined to a second cable section by means of a factory joint, and a system for performing a partial discharge test of the factory joint is indicated by a dashed rectangle;
Fig. 3 illustrates details of the dashed rectangle of fig. 2;
Fig. 4 illustrates details of the box 40 in fig. 3;
Fig. 5 illustrates details of the box 50 in fig. 3;
Fig. 6 corresponds to fig. 2, but where a third cable section has been joined to the joined cable.

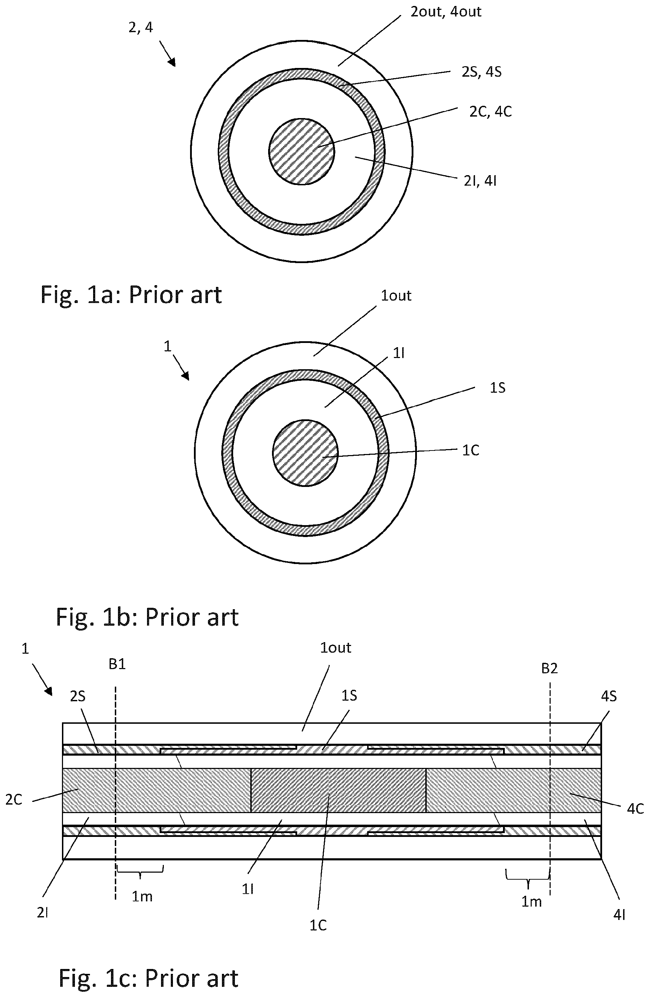

Fig. 1 shows a cross section of a first high voltage cable 2 which in the present example is joined to a second high voltage cable 4 identical to the first high voltage cable 2 by means of a factory joint 1. As the first high voltage cable 2 is identical to the second high voltage cable 4, fig. 1 is considered to illustrate the cross section of both such cables. In the present example, the cable sections are 250 kV XLPE (cross-linked polyethylene) cable sections.

The high voltage cable 2, 4 comprises a central conductor 2C, 4C and a semiconducting sheath 2S, 4S separated from the central conductor 2C, 4C by means of an insulation layer 2I, 4I. Outside of the semiconducting sheath 2S, 4S further insulation layers and protective layers may be provided. These outer layers are indicated as 2out, 4out.

It should further be noted that some high voltage cables comprise an inner semiconductive sheath (not shown in fig. 1a, 1b or 1c) outside of the central conductor 2C, 4C but inside of the insulation layer 21, 4I. Hence, the semiconducting sheath 2S, 4S outside of the insulation layer 21, 4I are in some cases referred to as the outer semiconductive sheath.

Fig. 1b and 1c shows the factory joint 1. The factory joint 1 comprises a joint conductor 1C joining the first conductor 2C with the second conductor 4C, a joint semiconductor sheath 1S joining the first semiconductor sheath 2S with the second semiconductor sheath 4S and an insulation layer 1I joining the insulation layers 2I, 4I. Outside of the semiconducting sheath 1S further insulation layers and protective layers lout may be provided.

It should be noted that fig. 1a, fig. 1b and fig. 1c and the description of these drawings above are schematically only - factory joints 1 may have various designs depending on the type of cable, the electrical and mechanical requirements for the joined cable etc. Factory joints may also be used to join different high voltage cables of different types.

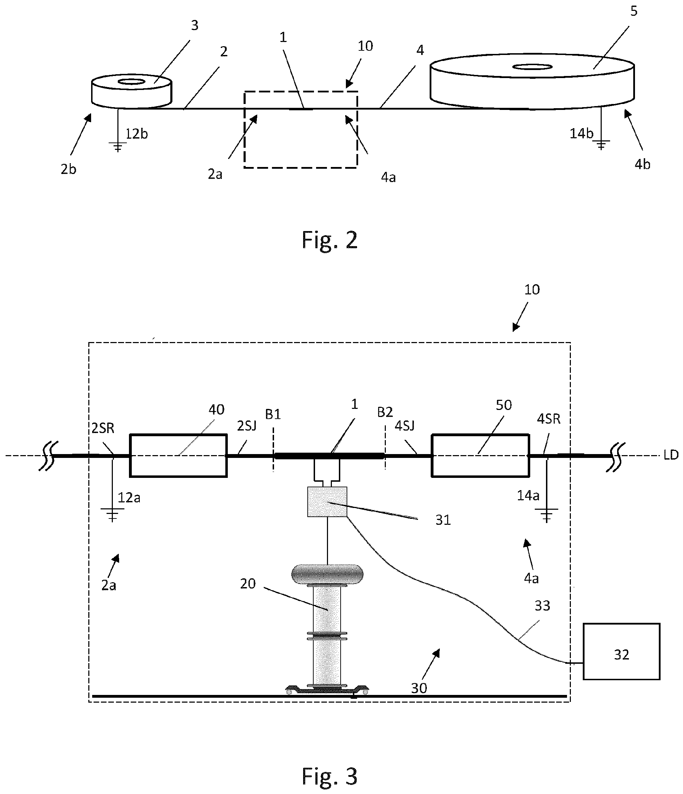

According to the factory joint definition above, stating that the defined length of a factory joint is the removed length of the metal sheath/outer semi-conducting screen plus 1 metre on each side of that length, there is a clear boundary at which the cables 2, 4 end and at which the joint 1 starts. The boundary between the first cable 2 and the joint 1 is indicated by a dashed line B1 (indicated at the end of the leftmost 1m curly bracket) and the boundary between the second cable 4 and the joint 1 is indicated as a dashed line B2 (indicated at the end of the rightmost 1m curly bracket) in fig. 1c. These boundaries B1, B2 are also indicated in fig. 3, fig. 4 and fig. 5.

It is now referred to fig. 2. Here it is shown a first cable drum 3, typically in the form of a basket, on which the first cable section 2 is spooled onto. One end of the first cable section 2 is referred to as a proximal end 2a as it is proximal to the factory joint 1. The opposite end is hence referred to as a distal end 2b. It is also shown a second cable drum 5, typically in the form of a turntable, on which the second cable section 4 is spooled onto. One end of the second cable section 4 is referred to as a proximal end 4a as it is proximal to the factory joint 1. The opposite end is hence referred to as a distal end 4b.

It should be noted that in the present embodiment, the first cable section 2 is one length of manufactured cable (which typically may have a length of more than a few kilometers for the 250 kV XLPE (cross-linked polyethylene) type of cable, while the second cable section 4 may comprise several such joined lengths of manufactured cable. Hence, the present invention is at least partially integrated with the joining process and the spooling process. According to the above CIGRE publication, a "manufactured length" is defined as a complete extrusion run or a part thereof, which normally does not contain any factory joints.

As shown in fig. 2, the proximal end 2a of the first cable section 2, the joint 1 and the proximal end 4a of the second cable section 4 are provided within the dashed box 10, indicating a test system for performing a partial discharge test of the factory joint 1.

It is now referred to fig. 3.

Initially, it should be mentioned that in fig. 2 and 3, the joint 1 is shown with a thicker line than the respective cable sections, which may be interpreted as the joint 1 having a larger cross section than the respective cables. However, as discussed above, the factory joint 1 preferably has the same outer diameter as the respective cable sections 2, 4. A longitudinally direction LD of the joint, the proximal end 2a of the first cable section 2 and the proximal end 4a of the second cable section 4 has also been indicated.

The system 10 comprises a first insulating system 40, a second insulating system 50, a high voltage transformer 20 and a partial discharge sensing system 30. These parts of the system 10 will be described in detail below.

### The first insulating system 40

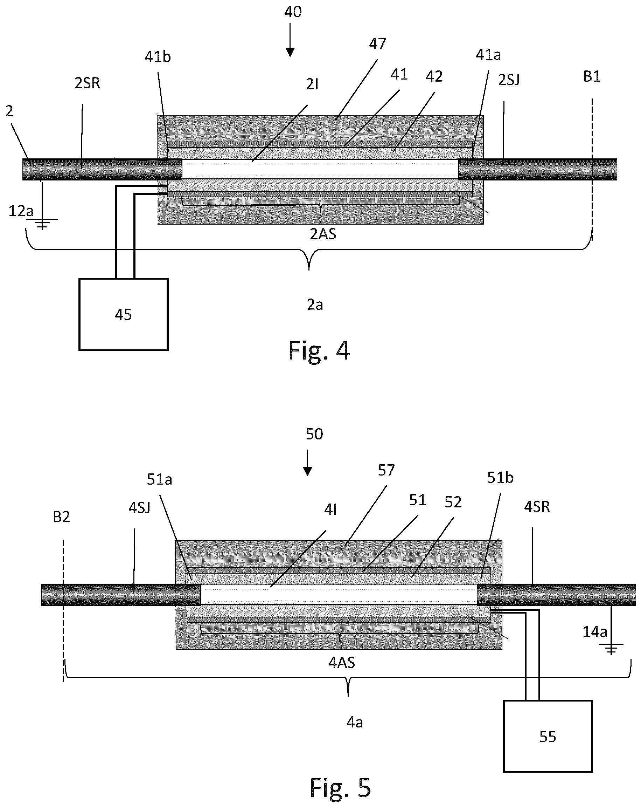

The first insulating system 40 is shown in fig. 4, and comprises a non-metallic housing 41 in which a compartment 42 is provided. The housing 41 may for example be made of an epoxy pipe. The non-metallic housing 41 has end openings 41a, 41b in each end. The first insulating system 40 further comprises a fluid-circulating system 45 for circulating de-ionized water through the compartment 42 during the test. The housing 41 may again be located within a gas insulated enclosure 47, filled with SF6 or an equivalent electrically insulating gas.

It is also shown in fig. 4 that the first semiconducting sheath 2S (together with layers/sheaths outside of the first semiconducting sheath 2S) has been removed from a section 2AS of the first cable section 2. This section 2AS, from which the first semiconducting sheath 2S has been removed, is provided in the compartment 42. Hence, a joint side part 2SJ of the first semiconductive sheath 2S has been electrically insulated from a remaining part 2SR of the first semiconductive sheath 2S. The length of the section 2AS may be approximately 2.5 m for the above 250 kV cable.

It should be noted that the joint side part 2SJ of the first semiconducting sheath 2S is sealingly engaged in the end opening 41a of the non-metallic housing 41, while the remaining part 2SR of the first semiconducting sheath 2S is sealingly engaged in the end opening 41b of the non-metallic housing 41, to prevent leakage of de-ionized water from the compartment 42.

It should further be noted that the joint side part 2SJ of the first cable section 2 is relatively short, as the distance between the first insulating system 40 and the first boundary B1 is relatively short, typically less than 2 meters.

### The second insulating system 50

The second insulating system 50 is shown in fig. 5, and is in the present embodiment similar to the first insulating system 40. The second insulating system50 comprises a non-metallic housing 51 in which a compartment 52 is provided. The non-metallic housing 51 has end openings 51a, 51b in each end. The second insulating system 50 further comprises a fluid-circulating system 55 for circulating de-ionized water through the compartment 52 during the test. The housing 51 may again be located within a gas insulated enclosure 57, filled with SF6 or an equivalent electrically insulating gas.

It is also shown in fig. 5 that the second semiconducting sheath 4S (together with layers/sheaths outside of the second semiconducting sheath 4S) has been removed from a section 4AS of the second cable section 4. This section 4AS, from which the second semiconducting sheath 4S has been removed, is provided in the compartment 52. Hence, a joint side part 4SJ of the second semiconductive sheath 4S has been electrically insulated from a remaining part 4SR of the second semiconductive sheath 4S.

It should be noted that the joint side part 4SJ of the second semiconducting sheath 4S is sealingly engaged in the end opening51a of the non-metallic housing 51, while the remaining part 4SR of the second semiconducting sheath 4S is sealingly engaged in the end opening 51b of the non-metallic housing 51, to prevent leakage of de-ionized water from the compartment 52.

### The high voltage transformer 20

The high voltage transformer 20 may be a 50/60 Hz transformer, a variable inductance series resonance high voltage generator or a variable frequency series resonance high voltage generator. These types of high voltage transformers are known for a person skilled in the art, and will not be described further in detail herein.

### The partial discharge sensing system 30

The partial discharge sensing system 30 is a system for sensing partial discharges in the factory joint 1 during the test period. The partial discharge sensing system 30 comprises a balanced partial discharge detector 31 and an analyzing system 32 provided in communication with the balanced partial discharge detector 31 by means of a fiber optic cable 33. The analyzing system 32 is typically an application running on a computer. One commercially available partial discharge sensing system 30 is the Omicron MBB1 measurement balanced bridge used together with the Omicron MPD600 measurement and analysis system, connected to a computer via a fiber optic bus controller, such as the Omicron MCU 502.

### Operation of the test system 10

The operation of the test system 10 will now be described.

Initially, it should be noted that the system 10 comprises a first earthing conductor 12a for grounding the remaining part 2SR of the first semiconductive sheath 2S. Hence, almost the entire semiconductive sheath 2S is connected to ground, except for the relatively short joint side part 2SJ of the semiconductive sheath 2S.

Similarly, the system 10 comprises a second earthing conductor 14a for grounding the remaining part 4SR of the second semiconductive sheath 4S. Again, almost the entire semiconductive sheath 4S is connected to ground, except for the relatively short joint side part 4SJ of the semiconductive sheath 4S.

Finally, the system 10 comprises a third earthing conductor 12b for grounding the first conductor 2C. This will typically connect the first conductor 2c, the joint conductor 1C and the second conductor 4C to ground. However, the system 10 may also comprise a fourth earthing conductor 14b for grounding the second conductor 4C at its distal end 4b.

Preferably, the first cable section 2 and the second cable section 4 have been tested separately before the joining process. If possible, the first cable section 2 and the second cable section 4 have been tested by means of a partial discharge test. This is today only possible for 250 kV XLPE cables shorter than 4 km. Hence, for longer cables, a high voltage withstand test is considered sufficient in order to test the insulation layers 2I, 4I.

Then the joining operation is performed, in which the proximal end 2a of the first cable section is joined to the proximal end 4a of the second cable section 4.

Then, the joint 1 is moved to the location of the partial discharge test, wherein the a joint side part 2SJ of the first semiconductive sheath 2S is electrically isolated from the remaining part 2SR of the first semiconductive sheath 2S by removing the semiconductive sheath of the section 2AS and by enclosing the section 2AS in the first insulating system 40 as described above.

Similarly, the joint side part 4SJ of the second semiconductive sheath 4S is electrically isolated from the remaining part 4SR of the second semiconductive sheath 4S by removing the semiconductive sheath of the section 4AS and by enclosing the section 4AS in the second insulating system 50 as described above.

Now, a test voltage is applied to the semiconducting sheath 1S of the factory joint 1S by means of the high voltage transformer 20 during a test period. Due to the conducting properties of the semiconducting sheaths, the test voltage will also be applied to the joint side part 2SJ of the first semiconductive sheath 2S and to the joint side part 4SJ of the second semiconductive sheath 4S. However, as the conductors 1C, 2C and 4C are grounded, and as the remaining parts 2SR, 4SR of the semiconductive sheaths 2S, 4S are grounded, partial discharges will only occur in the joint insulation layer 1I and possibly also in the insulation layers of the relatively short joint side parts 2SJ, 4SJ.

Any such partial discharges will be sensed by means of the partial discharge sensing system 30 during the test period.

If the test of the joint is satisfying, the entire joined cable comprising the first cable section, the joint and the second cable section is considered to be tested sufficiently.

Then, the sections 2AS, 4AS are moved out from the insulation systems 40, 50 and semiconductive sheaths are applied outside of the insulation layer again. Hence, there is one continuous layer of semiconductive sheath from the distal end 2b of the first cable section 2 to the distal end 4b of the second cable section 4 again. Then, further outer layers are applied to the sections 2AS, 4AS, and the entire joined cable is considered to be complete again.

In a final step, the first cable section 2 is spooled out from the basket 3 and onto the turntable 5.

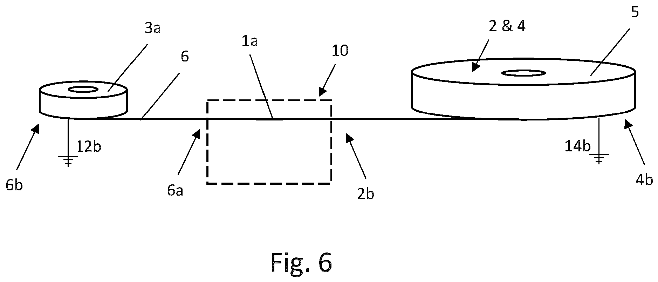

It is now referred to fig. 6. Here, a third cable section 6 on a basket 3a is joined to the previously joined cable (as indicated in fig. 6 to comprise the first cable section 2, the joint 1 and the second cable section 4) by means of a further factory joint 1b. Also this third cable section 6 has been tested before the joining operation. This further factory joint 1b is also tested by the above partial discharge test before the third cable section 6 and the further joint 1b is spooled onto the turntable 5. In this way, the further cable sections can be joined to the joined cable and each joint can be tested separately.

### Alternative embodiments

As discussed in the introduction above, the first cable and the second cable may be different from each other. Such different cables may still be joined by a factory joint and may be tested by the above method and system.

It should further be noted that even though the above example describes the 250 kV XLPE cable type, the same system and method may be used for testing other cable types.

## Claims

1. System (10) for performing a partial discharge test of a factory joint (1) joining a first high voltage cable section (2) and a second high voltage cable section (4);
wherein the first cable section (2) comprises a first conductor (2C) and a first semiconductive sheath (2S);
wherein the second cable section (4) comprises a second conductor (4C) and a second semiconductive sheath (4S);
wherein the factory joint (1) comprises a joint conductor (1C) joining the first conductor (2C) and the second conductor (4C) and a joint semiconductive sheath (1S) joining the first semiconductive sheath (2S) and the second semiconductive sheath (4S);
wherein the system (10) comprises:
- a first insulation system (40) for electrically insulating a joint side part (2SJ) of the first semiconductive sheath (2S) from a remaining part (2SR) of the first semiconductive sheath (2S);
- a second insulation system (50) for electrically insulating a joint side part (4SJ) of the second semiconductive sheath (4S) from a remaining part (4SR) of the second semiconductive sheath (4S);
- a first earthing conductor (12a) for grounding the remaining part (2SR) of the first semiconductive sheath (2S);
- a second earthing conductor (14a) for grounding the remaining part (4SR) of the second semiconductive sheath (4S);
- a third earthing conductor (12b, 14b) for grounding the first conductor (2C) and/or the second conductor (4C);
- a high voltage transformer (20) for supplying a test voltage to the semiconducting sheath (1S) of the factory joint (1S) during a test period;
- a partial discharge sensing system (30) for sensing partial discharges in the factory joint (1) during the test period.

2. System (10) according to claim 1, wherein the joint side part (2SJ) of the first semiconductive sheath (2S) is provided at a distance from the remaining part (2SR) of the first semiconductive sheath (2S) by removal of the first semiconductive sheath (2S) from a section (2AS) of the first cable (1) between the joint side part (2SJ) of the first semiconductive sheath (2S) and the remaining part (2SR) of the first semiconductive sheath (2S).

3. System (10) according to claim 2, wherein the first insulation system (40) comprises:
- a non-metallic housing (41) comprising a compartment (42) in which the section (2AS) of the first cable (2) from which the first semiconducting sheath (2S) has been removed is provided;
- a fluid-circulating system (45) for circulating de-ionized water through the compartment (42) during the test.

4. System (10) according to any one of claims 1-3, wherein the joint side part (4SJ) of the second semiconductive sheath (4S) is provided at a distance from the remaining part (4SR) of the second semiconductive sheath (4S) by removal of the second semiconductive sheath (4S) from a section (4AS) of the second cable (4) between the joint side part (4SJ) of the second semiconductive sheath (4S) and the remaining part (4SR) of the second semiconductive sheath (2S).

5. System (10) according to claim 4, wherein the second insulation system (50) comprises:
- a non-metallic housing (51) comprising a compartment (52) in which the section (4AS) of the second cable (4) from which the second semiconducting sheath (4S) has been removed is provided;
- a fluid-circulating system (55) for circulating de-ionized water through the compartment (52) during the test.

6. System (10) according to any one of the above claims, wherein the third earthing conductor is grounding the first conductor (2C) at a distal end (2b) thereof; and wherein the system (10) comprises a fourth earthing conductor (14b) for grounding the second conductor (4C) at a distal end (4b) thereof.

7. System (10) according to any one of the above claims, wherein the partial discharge sensing system (30) comprises a balanced partial discharge detector (31) and an analyzing system (32) provided in communication with the balanced partial discharge detector (31) by means of a fiber optic cable (33).

8. System (10) according to any one of the above claims, wherein the high voltage transformer (20) comprises a 50/60 Hz transformer, a variable inductance series resonance high voltage generator or a variable frequency series resonance high voltage generator.

9. System (10) according to any one of the above claims, wherein the first cable section (2) is at least partially spooled onto a first drum (3) and wherein the second cable section (4) is at least partially spooled onto a second drum (5).

10. Method for performing a test of a joined cable, wherein the method comprises:
- testing a first cable section (2);
- testing a second cable section (4);
- joining the first cable section (2) and the second cable section (4) by means of a factory joint (1) to form the joined cable;
- performing a partial discharge test of the factory joint (1) by performing the following steps
- electrically insulating a joint side part (2SJ) of the first semiconductive sheath (2S) from a remaining part (2SR) of the first semiconductive sheath (2S);
- electrically insulating a joint side part (4SJ) of the second semiconductive sheath (4S) from a remaining part (4SR) of the second semiconductive sheath (4S);
- grounding the remaining part (2SR) of the first semiconductive sheath (2S);
- grounding the remaining part (4SR) of the second semiconductive sheath (4S);
- grounding a first conductor (2C) of the first cable (2) and/or a second conductor (4C) of the second cable (4);
- applying a test voltage to a semiconducting sheath (1S) of the factory joint (1S) during a test period;
- sensing partial discharges in the factory joint (1) during the test period.

11. Method according to claim 10, wherein the step of testing the first cable section (2) comprises:
- testing the first cable section (2) by means of a high voltage withstand test or a partial discharge test.

12. Method according to claim 10 or 11, wherein the step of testing the second cable section (4) comprises:
- testing the second cable section (4) by means of a high voltage withstand test or a partial discharge test.

13. Method according to any one of claims 10 - 12, wherein the method comprises:
- testing a third cable section (6);
- joining the third cable section (6) to the previously joined cable by means of a further factory joint (1b);
- performing a partial discharge test of the further factory joint (1b).

## Patentansprüche

1. System (10) zur Durchführung eines Teilentladungstests für eine Fabrikverbindung (1), die ein erstes Hochspannungskabelteilstück (2) mit einem zweiten Hochspannungskabelteilstück (4) verbindet;
wobei das erste Kabelteilstück (2) einen ersten Leiter (2C) und einen ersten halbleitfähigen Mantel (2S) umfasst;
wobei das zweite Kabelteilstück (4) einen zweiten Leiter (4C) und einen zweiten halbleitfähigen Mantel (4S) umfasst;
wobei die Fabrikverbindung (1) einen den ersten Leiter (2C) mit dem zweiten Leiter (4C) verbindenden Verbindungsleiter (1C) sowie einen den ersten halbleitfähigen Mantel (2S) mit dem zweiten halbleitfähigen Mantel (4S) verbindenden halbleitfähigen Verbindungsmantel (1S) umfasst;
wobei das System (10) umfasst:
- ein erstes Isoliersystem (40) zum elektrischen Isolieren eines verbindungsseitigen Teils (2SJ) des ersten halbleitfähigen Mantels (2S) von dem restlichen Teil (2SR) des ersten halbleitfähigen Mantels (2S);
- ein zweites Isoliersystem (50) zum elektrischen Isolieren eines verbindungsseitigen Teils (4SJ) des zweiten halbleitfähigen Mantels (4S) von dem restlichen Teil (4SR) des zweiten halbleitfähigen Mantels (4S);
- einen ersten Erdungsleiter (12a) zum Erden des restlichen Teils (2SR) des ersten halbleitfähigen Mantels (2S);
- einen zweiten Erdungsleiter (14a) zum Erden des restlichen Teils (4SR) des zweiten halbleitfähigen Mantels (4S);
- einen dritten Erdungsleiter (12b, 14b) zum Erden des ersten Leiters (2C) und/oder des zweiten Leiters (4C);
- einen Hochspannungstransformator (20) zum Zuführen einer Prüfspannung zu dem halbleitfähigen Mantel (1S) der Fabrikverbindung (1) während eines Prüfzeitraums;
- ein Teilentladungserfassungssystem (30) zum Erfassen von Teilentladungen in der Fabrikverbindung (1) während des Prüfzeitraums.

2. System (10) nach Anspruch 1, wobei der verbindungsseitige Teil (2SJ) des ersten halbleitfähigen Mantels (2S) mit einer Beabstandung zu dem restlichen Teil (2SR) des ersten halbleitfähigen Mantels (2S) bereitgestellt wird, indem zwischen dem verbindungsseitigen Teil (2SJ) des ersten halbleitfähigen Mantels (2S) und dem restlichen Teil (2SR) des ersten halbleitfähigen Mantels (2S) dieser erste halbleitfähige Mantel (2S) von einem Teilstück (2AS) des ersten Kabels (1) entfernt ist.

3. System (10) nach Anspruch 2, wobei das erste Isoliersystem (40) umfasst:
- ein nichtmetallisches Gehäuse (41) umfassend ein Abteil (42), in welchem jenes Teilstück (2AS) des ersten Kabels (2), von dem der erste halbleitfähige Mantel (2S) entfernt worden ist, verläuft;
- ein Fluidzirkulationssystem (45), das dazu dient, während des Prüfverlaufs deionisiertes Wasser durch das Abteil (42) hindurch umzuwälzen.

4. System (10) nach einem der Ansprüche 1-3, wobei der verbindungsseitige Teil (4SJ) des zweiten halbleitfähigen Mantels (4S) mit einer Beabstandung zu dem restlichen Teil (4SR) des zweiten halbleitfähigen Mantels (4S) bereitgestellt wird, indem zwischen dem verbindungsseitigen Teil (4SJ) des zweiten halbleitfähigen Mantels (4S) und dem restlichen Teil (4SR) des zweiten halbleitfähigen Mantels (4S) dieser zweite halbleitfähige Mantel (4S) von einem Teilstück (4AS) des zweiten Kabels (4) entfernt ist.

5. System (10) nach Anspruch 4, wobei das zweite Isoliersystem (50) umfasst:
- ein nichtmetallisches Gehäuse (51) umfassend ein Abteil (52), in welchem jenes Teilstück (4AS) des zweiten Kabels (4), von dem der zweite halbleitfähige Mantel (4S) entfernt worden ist, verläuft;
- ein Fluidzirkulationssystem (55), das dazu dient, während des Prüfverlaufs deionisiertes Wasser durch das Abteil (52) hindurch umzuwälzen.

6. System (10) nach einem der obigen Ansprüche, wobei der dritte Erdungsleiter den ersten Leiter (2C) an einem distalen Ende (2b) erdet; und wobei das System (10) einen vierten Erdungsleiter (14b) umfasst, der dazu dient, den zweiten Leiter (4C) an einem distalen Ende (4b) zu erden.

7. System (10) nach einem der obigen Ansprüche, wobei das Teilentladungserfassungssystem (30) einen symmetrischen Teilentladungsdetektor (31) und ein Analysesystem (32) umfasst, das über ein Glasfaserkabel (33) mit dem symmetrischen Teilentladungsdetektor (31) kommuniziert.

8. System (10) nach einem der obigen Ansprüche, wobei der Hochspannungstransformator (20) einen 50/60-Hz-Transformator, einen Hochspannungsgenerator mit Serienresonanzkreis und variabler Induktanz oder einen Hochspannungsgenerator mit Serienresonanzkreis und variabler Frequenz umfasst.

9. System (10) nach einem der obigen Ansprüche, wobei das erste Kabelteilstück (2) zumindest teilweise auf eine erste Trommel (3) aufgespult ist und wobei das zweite Kabelteilstück (4) zumindest teilweise auf eine zweite Trommel (5) aufgespult ist.

10. Verfahren zur Durchführung eines Tests eines verbundenen Kabels, wobei das Verfahren umfasst, dass:
- ein erstes Kabelteilstück (2) geprüft wird;
- ein zweites Kabelteilstück (4) geprüft wird;
- das erste Kabelteilstück (2) und das zweite Kabelteilstück (4) mittels einer Fabrikverbindung (1) miteinander verbunden werden, um ein verbundenes Kabel zu bilden;
- ein Teilentladungstest der Fabrikverbindung (1) vorgenommen wird, indem die Schritte durchgeführt werden, dass:
- ein verbindungsseitiger Teil (2SJ) des ersten halbleitfähigen Mantels (2S) von einem restlichen Teil (2SR) des ersten halbleitfähigen Mantels (2S) elektrisch isoliert wird;
- ein verbindungsseitiger Teil (4SJ) des zweiten halbleitfähigen Mantels (4S) von einem restlichen Teil (4SR) des zweiten halbleitfähigen Mantels (4S) elektrisch isoliert wird;
- der restliche Teil (2SR) des ersten halbleitfähigen Mantels (2S) geerdet wird;
- der restliche Teil (4SR) des zweiten halbleitfähigen Mantels (4S) geerdet wird;
- ein erster Leiter (2C) des ersten Kabels (2) und/oder ein zweiter Leiter (4C) des zweiten Kabels (4) geerdet werden;
- an einen halbleitfähigen Mantel (1S) der Fabrikverbindung (1) während eines Prüfzeitraums eine Prüfspannung angelegt wird;
- Teilentladungen in der Fabrikverbindung (1) während des Prüfzeitraums erfasst werden.

11. Verfahren nach Anspruch 10, wobei der Schritt des Prüfens des ersten Kabelteilstücks (2) umfasst, dass:
- das erste Kabelteilstück (2) mittels eines Hochspannungs-Widerstandstests oder eines Teilentladungstests geprüft wird.

12. Verfahren nach Anspruch 10 oder 11, wobei der Schritt des Prüfens des zweiten Kabelteilstücks (4) umfasst, dass:
- das zweite Kabelteilstück (4) mittels eines Hochspannungs-Widerstandstests oder eines Teilentladungstests geprüft wird.

13. Verfahren nach einem der Ansprüche 10-12 wobei das Verfahren umfasst, dass:
- ein drittes Kabelteilstück (6) geprüft wird;
- das dritte Kabelteilstück (6) mittels einer weiteren Fabrikverbindung (1b) mit dem zuvor verbundenen Kabel verbunden wird;
- ein Teilentladungstest der weiteren Fabrikverbindung (1b) durchgeführt wird.

## Revendications

1. Système (10) permettant d'effectuer un essai de décharge partielle d'un joint d'usine (1) reliant une première section de câble haute tension (2) et une seconde section de câble haute tension (4) ; dans lequel la première section de câble (2) comprend un premier conducteur (2C) et une première gaine semi-conductrice (2S) ;
dans lequel la seconde section de câble (4) comprend un second conducteur (4C) et une seconde gaine semi-conductrice (4S) ;
dans lequel le joint d'usine (1) comprend un conducteur de joint (1C) reliant le premier conducteur (2C) et le second conducteur (4C) et une gaine semi-conductrice de joint (1S) reliant la première gaine semi-conductrice (2S) et la seconde gaine semi-conductrice (4S) ;
dans lequel le système (10) comprend :
- un premier système d'isolation (40) pour isoler électriquement une partie latérale de jonction (25J) de la première gaine semi-conductrice (2S) d'une partie restante (2SR) de la première gaine semi-conductrice (2S) ;
- un second système d'isolation (50) pour isoler électriquement une partie latérale de jonction (4SJ) de la seconde gaine semi-conductrice (4S) d'une partie restante (4SR) de la seconde gaine semi-conductrice (4S) ;
- un premier conducteur de mise à la terre (12a) pour mettre à la terre la partie restante (2SR) de la première gaine semi-conductrice (2S) ;
- un second conducteur de mise à la terre (14a) pour mettre à la terre la partie restante (4SR) de la seconde gaine semi-conductrice (4S) ;
- un troisième conducteur de mise à la terre (12b, 14b) pour mettre à la terre le premier conducteur (2C) et/ou le second conducteur (4C) ;
- un transformateur haute tension (20) pour fournir une tension d'essai à la gaine semi-conductrice (1S) du joint d'usine (1S) pendant une période d'essai ;
- un système de détection des décharges partielles (30) pour détecter les décharges partielles dans le joint d'usine (1) pendant la période d'essai.

2. Système (10) selon la revendication 1, dans lequel la partie latérale de jonction (25J) de la première gaine semi-conductrice (2S) est fournie à une certaine distance de la partie restante (2SR) de la première gaine semi-conductrice (2S) par le retrait de la première gaine semi-conductrice (2S) d'une section (2AS) du premier câble (1) entre la partie latérale de jonction (25J) de la première gaine semi-conductrice (2S) et la partie restante (2SR) de la première gaine semi-conductrice (2S).

3. Système (10) selon la revendication 2, dans lequel le premier système d'isolation (40) comprend :
- un boîtier non métallique (41) comprenant un compartiment (42) dans lequel se trouve la section (2AS) du premier câble (2) dont la première gaine semi-conductrice (2S) a été retirée ;
- un système de circulation de fluide (45) pour faire circuler de l'eau désionisée dans le compartiment (42) pendant l'essai.

4. Système (10) selon l'une des revendications 1 à 3, dans lequel la partie latérale de jonction (45J) de la seconde gaine semi-conductrice (4S) est fournie à une certaine distance de la partie restante (4SR) de la seconde gaine semi-conductrice (4S) par le retrait de la seconde gaine semi-conductrice (4S) d'une section (4AS) du second câble (4) entre la partie latérale de jonction (45J) de la seconde gaine semi-conductrice (4S) et la partie restante (4SR) de la seconde gaine semi-conductrice (2S).

5. Système (10) selon la revendication 4, dans lequel le second système d'isolation (50) comprend :
- un boîtier non métallique (51) comprenant un compartiment (52) dans lequel se trouve la section (4AS) du second câble (4) dont seconde gaine semi-conductrice (4S) a été retirée ;
- un système de circulation de fluide (55) pour faire circuler de l'eau désionisée dans le compartiment (52) pendant l'essai.

6. Système (10) selon l'une quelconque des revendications précédentes, dans lequel le troisième conducteur de mise à la terre relie le premier conducteur (2C) à son extrémité distale (2b) ; et dans lequel le système (10) comprend un quatrième conducteur de mise à la terre (14b) pour relier le second conducteur (4C) à son extrémité distale (4b).

7. Système (10) selon l'une quelconque des revendications précédentes, dans lequel le système de détection de décharge partielle (30) comprend un détecteur de décharge partielle équilibré (31) et un système d'analyse (32) en communication avec le détecteur de décharge partielle équilibré (31) au moyen d'un câble à fibres optiques (33).

8. Système (10) selon l'une quelconque des revendications précédentes, dans lequel le transformateur haute tension (20) comprend un transformateur 50/60 Hz, un générateur haute tension à résonance en série à inductance variable ou un générateur haute tension à résonance en série à fréquence variable.

9. Système (10) selon l'une quelconque des revendications précédentes, dans lequel la première section de câble (2) est au moins partiellement enroulée sur un premier tambour (3) et dans lequel la seconde section de câble (4) est au moins partiellement enroulée sur un second tambour (5).

10. Méthode d'essai d'un câble raccordé, dans laquelle la méthode comprend :
- tester une première section de câble (2) ;
- tester une seconde section de câble (4) ;
- joindre la première section de câble (2) et la seconde section de câble (4) au moyen d'un joint d'usine (1) pour former le câble joint ;
- effectuer un essai de décharge partielle du joint d'usine (1) en réalisant les étapes suivantes
- isoler électriquement une partie latérale de jonction (2SJ) de la première gaine semi-conductrice (2S) d'une partie restante (2SR) de la première gaine semi-conductrice (2S) ;
- isoler électriquement une partie latérale de jonction (4SJ) de la seconde gaine semi-conductrice (4S) d'une partie restante (4SR) de la seconde gaine semi-conductrice (4S) ;
- mettre à la terre la partie restante (2SR) de la première gaine semi-conductrice (2S) ;
- mettre à la terre la partie restante (4SR) de la seconde gaine semi-conductrice (4S) ;
- mettre à la terre un premier conducteur (2C) du premier câble (2) et/ou d'un second conducteur (4C) du second câble (4) ;
- appliquer une tension d'essai à une gaine semi-conductrice (1S) du joint d'usine (1S) pendant une période d'essai ;
- détecter les décharges partielles dans le joint d'usine (1) pendant la période d'essai.

11. Procédé selon la revendication 10, dans lequel l'étape de test de la première section de câble (2) comprend :
- tester la première section de câble (2) au moyen d'un test de résistance à la haute tension ou d'un test de décharge partielle.

12. Procédé selon la revendication 10 ou 11, dans lequel l'étape de test de la seconde section de câble (4) comprend :
- tester la seconde section de câble (4) au moyen d'un test de résistance à la haute tension ou d'un test de décharge partielle.

13. Procédé selon l'une des revendications 10 à 12, dans lequel ledit procédé comprend :
- tester une troisième section de câble (6) ;
- relier la troisième section de câble (6) au câble précédemment raccordé au moyen d'un autre joint d'usine (1b) ;
- effectuer un essai de décharge partielle de l'autre joint d'usine (1b).
